# EUROPEAN PATENT APPLICATION

(11) **EP 4 694 580 A1**
(43) Date of publication of application: **11.02.2026**
(21) Application number: 24784583.7
(22) Date of filing: 06.02.2024
(51) Int. Cl.: H05H 7/08, H01J 27/18, H01J 37/08, H05H 13/02

(54) **ION SOURCE, ACCELERATOR, AND PARTICLE BEAM THERAPY SYSTEM**

(30) Priority: 04.04.2023 JP 2023061006
(71) Applicant: HITACHI HIGH-TECH CORPORATION, Tokyo 105-6409 (JP)
(72) Inventor: SEKI, Takayoshi, Tokyo 100-8280 (JP)
(74) Representative: MERH-IP Matias Erny Reichl Hoffmann Patentanwälte PartG mbB
(86) International application number: PCT/JP2024/003915
(87) International publication number: WO 2024/209780

(57) **Abstract**

To enhance maintainability. An ion source 3 that extracts an extraction beam 15 from an acceleration cavity A in a magnetic pole 1 includes a chimney 22, at least one cathode 23, a radio frequency acceleration electrode 8, and a dummy electrode 9. The chimney is fixed to the acceleration cavity. The at least one cathode is insertably disposed within the chimney. The cathode is a pair of cathodes that are inserted from both sides of the chimney and arranged to face each other. The radio frequency acceleration electrode accelerates the extraction beam. The dummy electrode is disposed opposite to or in parallel with the high frequency acceleration wave electrode. The chimney is electrically connected to the dummy electrode via a contact C.

## Description

### Technical Field

The present invention relates to an ion source, an accelerator, and a particle beam therapy system.

### Background Art

As background art of the present technical field, for example, PTL 1 is disclosed. The synchrocyclotron of PTL 1 includes a magnetic structure that applies a magnetic field to a cavity, a particle source that applies a plasma column to the cavity, and a voltage source that applies a radio frequency (RF) voltage to the cavity to accelerate particles from the plasma column in an acceleration region.

### Citation List

### Patent Literature

PTL 1: JP 2011-505670 A

### Summary of Invention

### Technical Problem

The ion source described in PTL 1 has a housing for holding a plasma column. The housing is interrupted in the acceleration region so as to expose the plasma column. To accelerate the particles from the plasma column in the acceleration region, the voltage source is configured to provide a radio frequency (RF) voltage to the cavity.

However, in the structure described in PTL 1, there is a problem that the extracted ion beam diverges and the beam current decreases due to the disturbance of the electric field due to the insufficient positional accuracy of the separated plasma column and the disturbance of the beam extraction electric field due to the column space generated by the separation. For this reason, when the damaged cathode is replaced, it is necessary to perform position adjustment while extracting the beam every time, and it takes time to perform ion source replacement and position adjustment work, and there is a problem that the device operation rate is lowered.

Therefore, the present invention has been made in view of the above problems, and an object thereof is to provide a technique for improving maintainability.

### Solution to Problem

To solve the above object, the present invention provides an ion source for extracting an ion beam from an acceleration cavity in a magnetic pole, the ion source including: a chimney fixed to the acceleration cavity; and at least one cathode insertably disposed in the chimney.

### Advantageous Effects of Invention

According to the present invention, maintainability can be enhanced.

Problems, configurations, and effects other than those described above will be clarified by the following description of embodiments.

### Brief Description of Drawings

[FIG. 1] FIG. 1 is a diagram illustrating an overall configuration of a particle beam therapy system according to a first embodiment.
[FIG. 2] FIG. 2 is a longitudinal sectional view of the circular accelerator according to the first embodiment.
[FIG. 3] FIG. 3 is a cross-sectional view of the circular accelerator according to the first embodiment.
[FIG. 4] FIG. 4 is a schematic cross-sectional view before insertion of a cathode around an ion source according to the first embodiment.
[FIG. 5] FIG. 5 is a schematic cross-sectional view after insertion of a cathode around an ion source according to the first embodiment.
[FIG. 6] FIG. 6 is a schematic cross-sectional view illustrating an alignment structure of an ion source of FIG. 5.
[FIG. 7] FIG. 7 is a schematic cross-sectional view before insertion of a cathode around an ion source according to a second embodiment.
[FIG. 8] FIG. 8 is a schematic cross-sectional view after insertion of a cathode around an ion source according to the second embodiment.

### Description of Embodiments

Hereinafter, specific examples of an ion source, an accelerator, and a particle beam therapy system according to an embodiment of the present invention will be described with reference to the drawings. Note that the present invention is not limited by the embodiments, but is indicated by the claims.

### First Embodiment

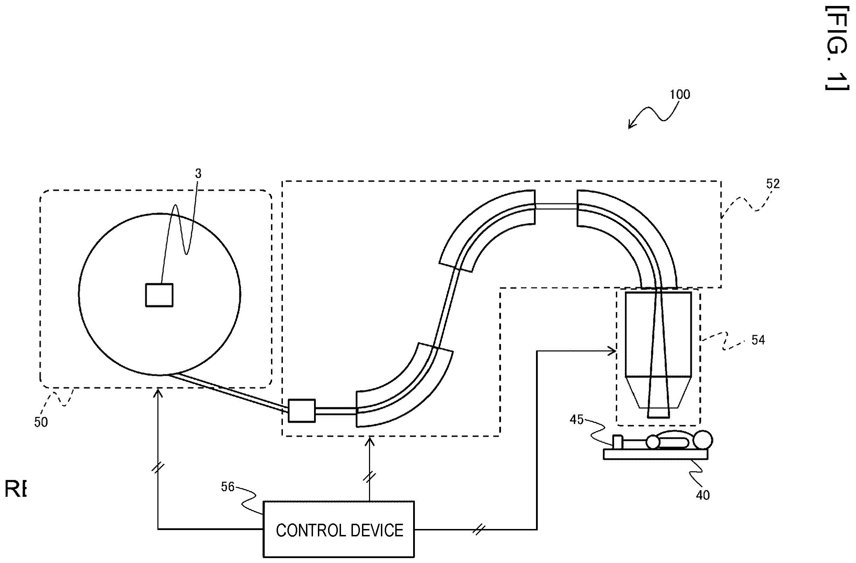

Hereinafter, an ion source, an accelerator, and a particle beam therapy system according to a first embodiment of the present invention will be described with reference to FIGS. 1 to 6. First, an overall configuration of a particle beam therapy system and a configuration of a related device will be described with reference to FIG. 1.

FIG. 1 is a diagram illustrating an overall configuration of a particle beam therapy system according to the first embodiment.

In FIG. 1, a particle beam therapy system 100 includes a circular accelerator 50 as an example of a cyclotron type "accelerator", a beam transport system 52, an irradiation device 54, a treatment couch 40, and a control device 56.

In the particle beam therapy system 100, ions generated by the ion source 3 are accelerated by the circular accelerator 50 to form an ion beam. The accelerated ion beam is extracted from the circular accelerator 50 and transported to the irradiation device 54 by the beam transport system 52. The transported ion beam is shaped to match the shape of the affected area by the irradiation device 54, and the target of a patient 45 lying on the treatment couch 40 is irradiated with a predetermined amount of the ion beam. The operation of each device and equipment in the particle beam therapy system 100 including the circular accelerator 50 is controlled by the control device 56.

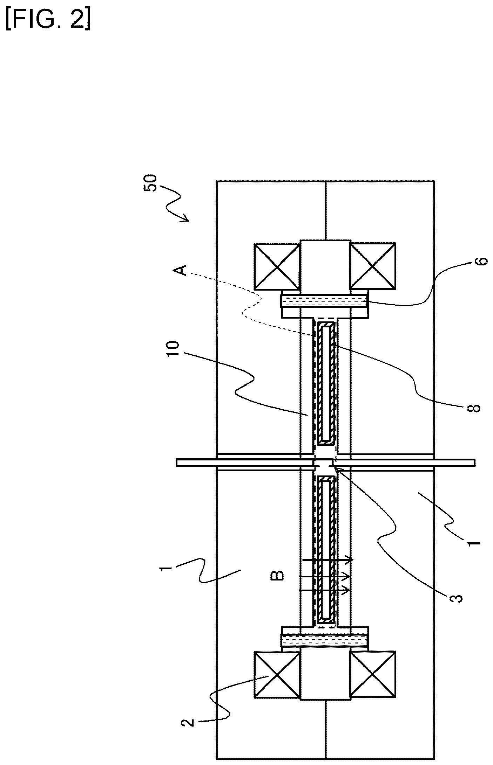

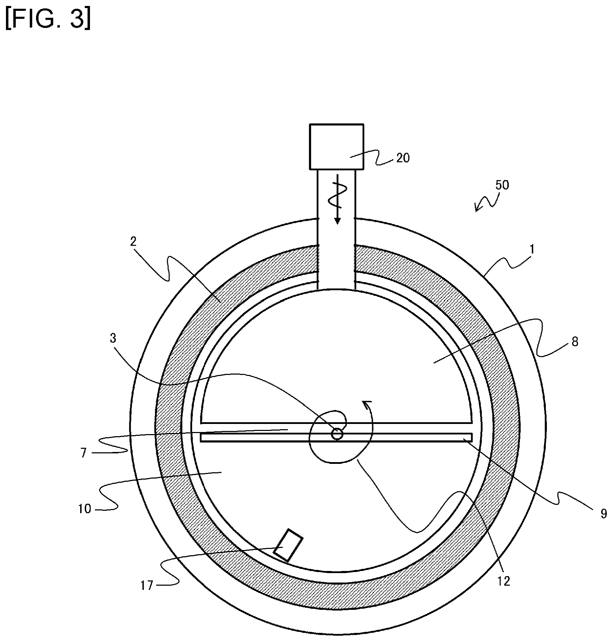

Next, the structure of the circular accelerator 50 will be described with reference to FIGS. 2 and 3.

FIG. 2 is a longitudinal sectional view of the circular accelerator according to the first embodiment of FIG. 1, and FIG. 3 is a cross-sectional view of the circular accelerator according to the first embodiment of FIG. 1.

As illustrated in FIGS. 2 and 3, the cyclotron type circular accelerator 50 includes a pair of main magnetic poles 1 as an example of "magnetic pole", a toroidal coil 2, a vacuum vessel 6, a radio frequency acceleration electrode 8, an ion source 3, and a dummy electrode 9.

The pair of main magnetic poles 1 is magnetic bodies installed so as to face each other, and is made of, for example, iron. In the main magnetic pole 1, a magnetic pole 10 is provided between magnetic poles facing each other so as to generate a closed orbit 12 of the ion beam, and a magnetic field is generated between the magnetic poles. The main magnetic pole 1 generates a magnetic field B by the magnetic pole 10 and generates a focusing force of a circulating ion beam by forming an inclined magnetic field outward from the circling center of the magnetic pole 10, thereby realizing a stable circling. The opposing upper and lower surfaces between the magnetic pole gaps where the magnetic field B is generated in the main magnetic pole 1 have a symmetrical shape. Alternatively, the upper and lower surfaces may be magnetic poles having a shape that adds a convergence effect by having a magnetic pole shape provided with protrusions and recesses in the traveling direction of the ion beam.

The vacuum vessel 6 is sandwiched by the main magnetic pole 1, and forms one vacuum vessel with the magnetic pole 10 as an inner surface. The vacuum vessel 6 is a nonmagnetic body. The magnetic pole gap may be separately provided with a separated vacuum vessel in which the magnetic pole 10 is not the inner surface of the vacuum vessel.

The toroidal coil 2 is installed closer to the atmosphere than the vacuum vessel 6, and generates the magnetic field B between the pair of upper and lower main magnetic poles 1. The toroidal coil 2 can similarly generate a magnetic field in both a coil made of a normal conducting material and a coil made of a superconducting material. The toroidal coil 2 may be installed in the vacuum vessel 6, and is not particularly limited.

The ion source 3 is inserted from the vertical direction of the magnetic pole 10 and fixed to an acceleration cavity A in the magnetic pole 10. The ion source 3 may be inserted from the lateral direction of the magnetic pole 10, but the direction is not particularly limited. When a radio frequency is supplied from a radio frequency power supply 20, the ion source 3 and the dummy electrode 9 have the same potential. When plasma is generated in the ion source 3 and a radio frequency is supplied from the radio frequency power supply 20, an extraction beam 15 as an example of an "ion beam" is formed by a radio frequency electric field generated between the radio frequency electrode 8 and the ion source 3 and between the radio frequency electrode 8 and the dummy electrode 9. The formed extraction beam 15 is accelerated by the magnetic field B of the magnetic pole 10 and the electric field generated in a gap 7 between the radio frequency acceleration electrode 8 and the dummy electrode 9, and circulates while drawing the helical-shaped closed orbit 12. The extraction beam 15 is accelerated every time the beam passes through the gap 7, is accelerated to a predetermined energy while increasing the energy, and is then extracted to the outside of the main magnetic pole 1 by an extraction device 17. The extraction device 17 deflects a trajectory by a magnetic field and an electric field.

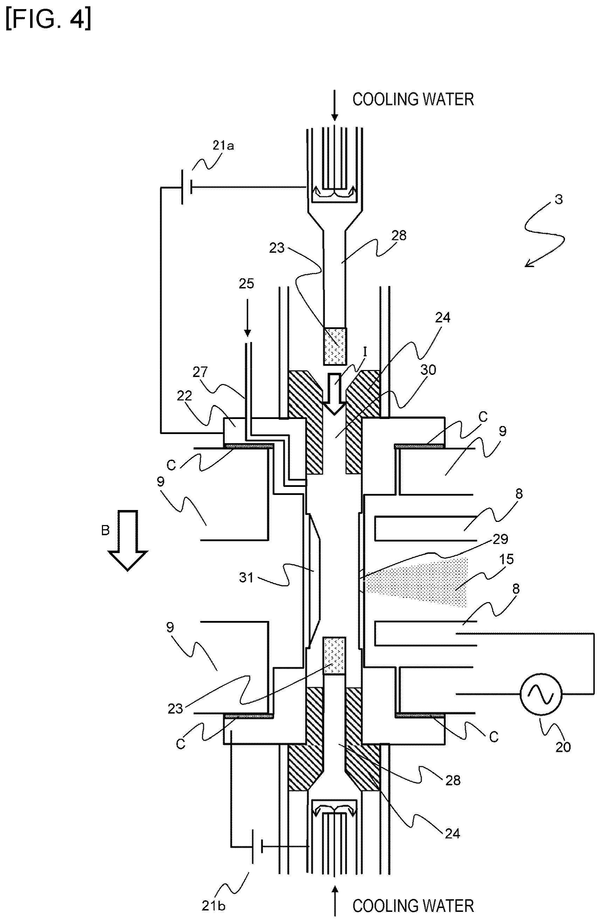

Next, details of the ion source 3 will be described with reference to FIGS. 4 to 6.

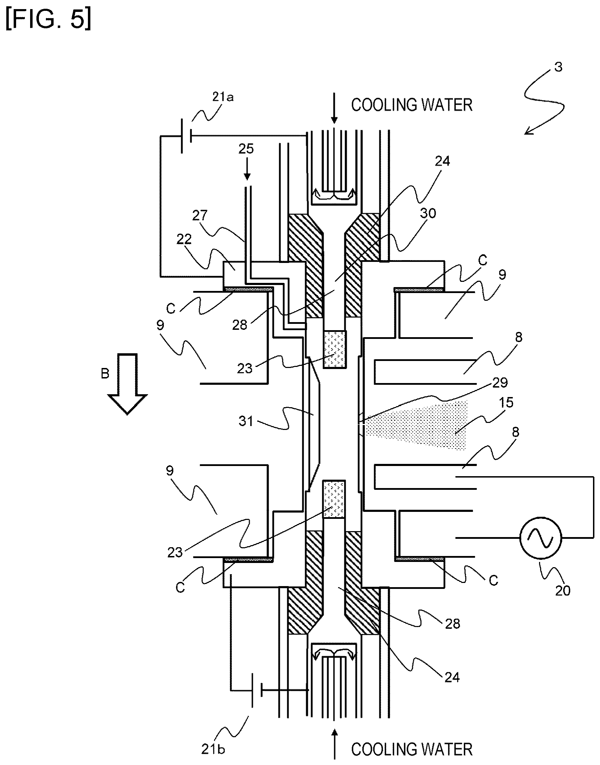

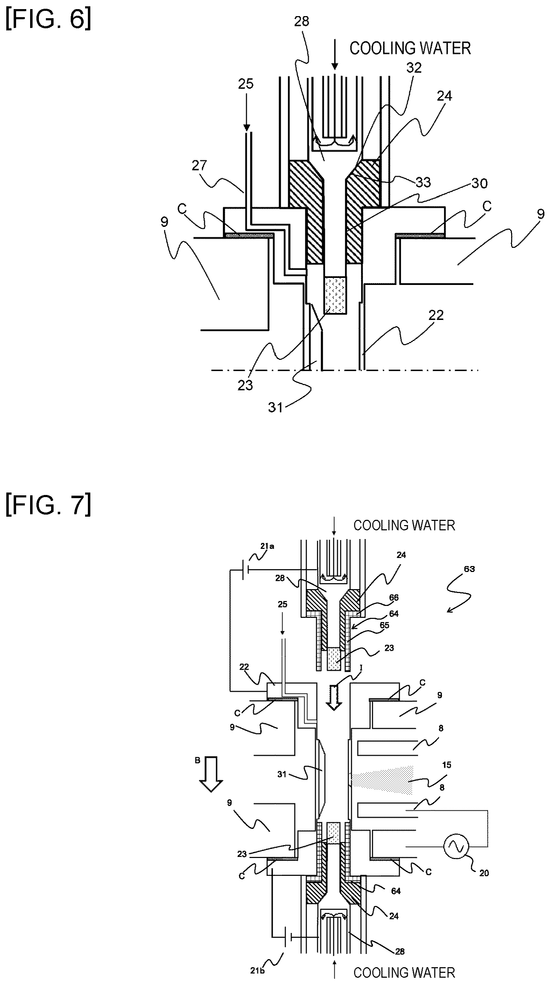

FIG. 4 is a schematic sectional view before insertion of the cathode around the ion source according to the first embodiment, FIG. 5 is a schematic sectional view after insertion of the cathode around the ion source according to the first embodiment, and FIG. 6 is a schematic sectional view illustrating an alignment structure of the ion source of FIG. 5.

FIG. 4 illustrates an example of a case where the ion source 3 is formed by fixing a chimney 22 to the dummy electrode 9 and inserting cathodes 23 and cathode holders 28 into the chimney 22 from the vertical direction. FIG. 6 illustrates an example of the structure of a cathode fixture 24 having a tapered structure for positioning and providing insulating support with the chimney 22 when the cathode holder 28 is inserted. The cathode 23 and the cathode holder 28 in the upper part of FIG. 4 are in a state before insertion, and the cathode 23 and the cathode holder 28 in the lower part of FIG. 4 are in a state after insertion. The upper and lower cathodes 23 may have the same shape or different shapes.

The ion source 3 of FIG. 4 is an example of a Penning ionization gauge (PIG) type ion source including a pair of cathodes 23 that generate electrons, a chimney 22, and a pair of discharge power supplies 21a and 21b. The pair of discharge power supplies 21a and 21b can use different power supplies or can be shared by one power supply, and is not limited.

The dummy electrode 9 is disposed opposite to or parallel to the radio frequency acceleration electrode 8.

The chimney 22 is formed in a cylindrical shape. An extraction hole 29 through which the extraction beam 15 is extracted is provided on the side of the radio frequency acceleration electrode 8 in the peripheral wall of the chimney 22. A bulging portion 30 bulging toward the extraction hole 29 is formed on an inner peripheral surface of the chimney 22 facing the extraction hole 29.

The chimney 22 is fixed to the dummy electrode 9 via a contact C. The contact C electrically connects the chimney 22 and the dummy electrode 9. The distance between the chimney 22 and the radio frequency electrode 8 is set so as to form an acceleration electric field that reduces the divergence of the extraction beam 15.

One end portion of the cathode 23 is held by the cathode holder 28. When the pair of cathodes 23 held by the pair of cathode holders 28 are respectively inserted into the chimney 22 from the openings on both sides of the chimney 22 along an insertion direction I, the respective cathodes 23 are arranged to face each other. A distal end portion of the cathode 23 inserted into the chimney 22 overlaps the bulging portion 30 in the insertion direction I of the cathode 23.

The cathode holder 28 is supported by the cathode fixture 24 that is fixed to the chimney 22. The cathode fixture 24 positions and insulates the cathode holder 28 inserted into the chimney 22 from the chimney 22. Further, the cathode holder 28 has a cooling structure to prevent abnormal damage due to overheating of the cathode.

The chimney 22 has a role of confining plasma and a role of forming an accelerating electric field, and plasma is formed by discharge between the cathode 23 and the chimney 22. Thus, the chimney 22 may also be referred to as an anode.

The cathode 23 is made of a material in which electron emission easily occurs, and is tungsten (W), lanthanum hexaboride (LaB6), or the like, for example. However, the material of the cathode 23 is not particularly limited. Further, cathode 23 may be a cold cathode that is not heated, or a hot cathode of a type in which electrons are emitted by forced heating by flowing a current. However, the life of the cathode 23 is better in the cold cathode. The chimney 22 is made of a material resistant to heat, and is preferably tantalum (Ta) or copper (Cu) having good thermal conduction. However, the material of the chimney 22 is not particularly limited.

The cathode fixture 24 is made of an insulator, and is made of alumina (Al2O3), boron nitride (BN), or the like. However, the material of the cathode fixture 24 is not particularly limited as long as it is a material that withstands high temperature and has excellent insulating properties.

The ion source 3 emits electrons from the cathode 23. The cathode 23 is damaged by the generated plasma and the discharge with the chimney 22. In the damaged cathode 23, stable plasma generation becomes difficult. Therefore, it is necessary to periodically replace the cathode 23. When the ion source 3 including the chimney 22 is replaced, it is necessary to adjust the position of the chimney 22 and the radio frequency electrode 8 after the replacement, and the adjustment time affects the device operation rate. Since it is determined that the chimney 22 is not damaged as much as the cathode 23 and does not need to be replaced at the same cycle as the cathode 23 from the test results so far and the like, it is possible to replace only the cathode 23. Furthermore, since the position of the cathode 23 does not affect the distance between the chimney 22 and the radio frequency electrode 8, there is a likelihood of installation accuracy and there is no influence on the divergence of the extraction beam 15. Therefore, readjustment after replacement of the cathode 23 by maintenance is facilitated.

FIG. 6 is a schematic cross-sectional view illustrating an alignment structure of the ion source of FIG. 5.

Structures of the cathode holder 28 and the cathode fixture 24 having a tapered structure for positioning and providing insulating support between the cathode holder 28 and the chimney 22 will be described.

The cathode fixture 24 is provided with an insertion hole 31 into which the cathode 23 is inserted. A tapered surface 32 whose diameter increases toward the side opposite to the insertion direction I of the cathode 23 is formed at the opening edge of the insertion hole 31. A tapered surface 33 that faces the tapered surface 32 when inserted into the insertion hole 31 is formed at the base of the cathode holder 28. With such a tapered structure, the respective tapered surfaces 32 and 33 come into contact with each other when the cathode 23 is inserted into the chimney 22, and the cathode 23 can be accurately installed at a prescribed position of the chimney 22. It is also possible to perform positioning by limiting the hole diameter of the insertion hole 31 without providing a tapered structure. The tapered structure also acts as a guide when inserting the cathode 23 into the chimney 22.

The ion source 3 operates as follows, and generates plasma to be a source of the ion beam. First, a voltage is applied between the cathode 23 and the chimney 22 by the discharge power supplies 21a and 21b. By setting the cathode 23 to a negative potential with respect to the chimney 22, electrons are emitted toward the chimney 22. A gas introduction pipe 27 is connected to the chimney 22, and a sample gas 25 is supplied into the chimney 22 via the gas introduction pipe 27. Plasma is generated by the emitted electrons and the sample gas 25, and the extraction beam 15 is formed from the extraction hole 29 for ion beam extraction provided in a peripheral wall of the chimney 22 by an acceleration electric field generated between the radio frequency electrode 8 and the chimney 22. At this time, due to the magnetic field B generated at the magnetic pole 10, electrons perform a spiral motion, so that the stay time in the chimney 22 is extended, and the plasma generation efficiency is further increased.

Next, effects of the present embodiment will be described.

The ion source 3 of the present embodiment described above is the ion source 3 that extracts an extraction beam from the acceleration cavity A in the main magnetic pole 1. The ion source 3 includes the chimney 22 and the pair of cathodes 23. The chimney 22 is fixed to the acceleration cavity A. The pair of cathodes 23 is inserted from both sides of the chimney 22 and disposed to face each other.

As a result, when the cathode 23 is damaged, only the cathode 23 can be replaced. As a result, maintainability of the ion source 3 can be improved.

Further, the radio frequency acceleration electrode 8 that accelerates the extraction beam 15 and the dummy electrode 9 disposed opposite to or in parallel with the radio frequency acceleration electrode 8 are provided, and the chimney 22 is electrically connected to the dummy electrode 9 via the contact C. As a result, even in a case where the cathode 23 in the ion source 3 for generating plasma is replaced, since the chimney 22 and the radio frequency electrode 8 are not assembled again, there is no variation in the electrode interval, and it is unnecessary to adjust the position of the chimney 22 for readjustment of the orbit of the extraction beam 15.

Further, the chimney 22 is formed in a cylindrical shape, and the extraction hole 29 for extracting the extraction beam 15 is provided on the side of the radio frequency acceleration electrode 8 in the peripheral wall of the chimney 33, whereby the chimney 22 is not divided on the closed orbit, so that the disturbance of the acceleration electric field is less likely to occur, the current loss of the circulating beam is also reduced, and the utilization efficiency of the extracted ion beam 15 can be improved.

Further, the bulging portion 31 bulging toward the extraction hole 29 is formed on an inner peripheral surface of the chimney 22 facing the extraction hole 29, and a distal end portion of the cathode 23 overlaps the bulging portion 31 in the insertion direction I of the cathode 23. As a result, the bulging portion 31 approaches the extraction hole 29, and the current value can be increased.

Further, the chimney 22 is formed in a cylindrical shape, and a pair of cathodes 23 is inserted from openings on both sides. As a result, since the chimney 22 is not divided on the closed orbit, the disturbance of the acceleration electric field is less likely to occur, the current loss of the circulating beam is also reduced, and the utilization efficiency of the ion beam can be improved.

Further, the cathode holder 28 that holds one end of the cathode 23 and the cathode fixture 24 that is provided with the insertion hole 31 into which the cathode 23 is inserted and that supports the cathode holder 28 when the cathode 23 is inserted into the insertion hole 31 are provided, and the tapered surface 32 that expands in diameter toward a side opposite to the insertion direction I is formed in an opening of the insertion hole 31 on a side opposite to the cathode insertion direction I. As a result, the cathode 23 can be inserted into the chimney 22 while being guided by the tapered surface 32, and the positional accuracy of the cathode 23 inserted into the chimney 22 can be improved. Furthermore, since the structure of the cathode holder 28 can be simplified, the cathode 23 can be easily replaced as compared with a conventional internal ion source as described in PTL 1, reassembly is facilitated, assembly time can be shortened, and the operation rate of the apparatus can be improved.

Further, the cathode holder 28 is formed with a tapered surface 33 that faces the tapered surface 32, thereby further enhancing insertion guidance and positional accuracy of the cathode 23.

The circular accelerator 50 includes the ion source 3. As a result, since the device can be started in a short time, it is possible to provide a circular accelerator capable of improving the operation rate of the device.

### Second Embodiment

The second embodiment shows an example of an ion source 63 having a structure in which a cathode holder 28, a cathode 23, a cathode fixture 24, and an anode electrode 64 are integrally inserted into a chimney 22. In the following description, the same components as those in the first embodiment are denoted by the same reference numerals, and the description thereof will be simplified.

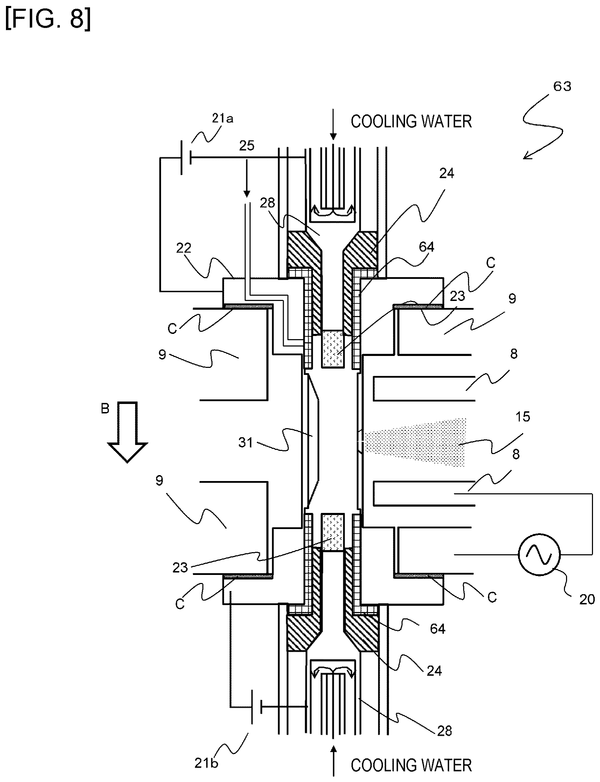

FIG. 7 is a schematic cross-sectional view before insertion of the cathode around the ion source according to the second embodiment, and FIG. 8 is a schematic cross-sectional view after insertion of the cathode around the ion source according to the second embodiment.

The ion source 63 includes an anode electrode 64 as an example of an "anode". The anode electrode 64 is attached to the outer peripheral side of the cathode 23 via the cathode holder 24. The anode electrode 64 includes a cylindrical portion 65 inserted into the chimney 22 and a flange portion 66 extending outward from one end of the cylindrical portion. The anode electrode 64 has the same potential as the chimney 22. Similarly to the chimney 22, the anode electrode 64 is made of tantalum (Ta), copper (Cu), or the like.

Similarly to the cathode fixture 24, a tapered structure may be provided at the end of the chimney 22 into which the structure in which the cathode holder 28, the cathode 23, the cathode fixture 24, and the anode electrode 64 are integrated is inserted to perform positioning. That is, a tapered surface that increases in diameter toward the side opposite to the insertion direction I of the cathode 23 may be formed at the opening edge of the chimney 22. As a result, the cathode holder 28, the cathode 23, the cathode fixture 24, and the anode electrode 64 can be inserted into the chimney 22 while being integrally guided by the tapered surface, and the positional accuracy of the cathode 23 inserted into the chimney 22 can be enhanced. Further, the anode electrode 64 may be formed with a tapered surface that faces the tapered surface of the chimney 22 when inserted into the chimney 22. As a result, it is possible to further improve insertion guidance and positional accuracy in which the cathode holder 28, the cathode 23, the cathode fixture 24, and the anode electrode 64 are integrated.

By providing the anode electrode 64 in a portion susceptible to damage of the chimney 22, damage of the chimney 22 can be further suppressed. The anode electrode 64 that is susceptible to damage is replaceable together with the cathode 23. However, since the anode electrode 64 is separated from the chimney 22, the positions of the chimney 22 and the radio frequency electrode 8 are not changed. Therefore, since the acceleration electric field is not affected, readjustment of the extraction beam 15 after replacement of the cathode 23 becomes unnecessary. Other structures and operations are the same as those described with reference to FIGS. 4 and 5, and will be omitted.

Note that the present invention is not limited to the above-described embodiments, and includes various modifications. For example, the above-described embodiments have been described in detail for easy understanding of the present invention, and are not necessarily limited to those having all the described configurations. In addition, a part of the configuration of a certain embodiment can be replaced with the configuration of another embodiment, and the configuration of another embodiment can be added to the configuration of a certain embodiment. In addition, it is possible to add, delete, and replace other configurations for a part of the configuration of each embodiment.

For example, in FIGS. 4 to 8, the upper and lower portions have the same structure. Furthermore, the first and second embodiments are examples in which the cathode 23 is inserted from the upper portion and the lower portion of the main magnetic pole 1, respectively. However, even if the cathode 23 is inserted from the side of the main magnetic pole 1, the same operation can be performed. Further, at least one cathode 23 may be configured to be insertably disposed in the chimney 22.

Furthermore, as a type of the circular accelerator 50, a cyclotron type accelerator having a magnetic pole provided with protrusions and recesses in the magnetic pole 10 or a synchrocyclotron type accelerator that has a magnetic pole inclined from the center of the magnetic pole 10 and modulates the frequency of radio frequency acceleration can also obtain the same effect.

The synchrocyclotron type accelerator is a type of accelerator in which a cyclotron is improved, and applies a frequency-modulated radio frequency electric field to charged particles that circularly move between large magnetic poles to repeatedly accelerate the charged particles. Also, at the speed of light, the mass of the accelerated particles increases due to the relativistic effect, and the period of the circular motion of the charged particles in the magnetic field increases in proportion to the mass. The phase deviation from the radio frequency voltage caused by this is removed by modulating the frequency.

Since the synchrocyclotron type accelerator has a configuration similar to that of the cyclotron type accelerator, the ion source 3 can be disposed in the main magnetic pole 1, and a similar effect can be obtained. Reference Signs List

- 1: main magnetic pole
- 3: ion source
- 8: radio frequency acceleration electrode
- 9: dummy electrode
- 15: extraction beam
- 22: chimney
- 23: cathode
- 24: cathode fixture
- 28: cathode holder
- 29: extraction hole
- 30: bulging portion
- 31: insertion hole
- 32: tapered surface
- 33: tapered surface
- 43: ion source
- 44: anode
- 50: circular accelerator
- 52: beam transport system
- 54: irradiation device
- 63: ion source
- 64: anode electrode
- 100: particle beam therapy system
- A: acceleration cavity
- C: contact
- I: insertion direction

## Claims

1. An ion source configured to extract an ion beam from an acceleration cavity in a magnetic pole, the ion source comprising:
a chimney secured to the acceleration cavity; and
at least one cathode insertably disposed within the chimney.

2. The ion source according to claim 1, wherein the cathode is
a pair of cathodes respectively inserted from both sides of the chimney and arranged to face each other.

3. The ion source according to claim 1, further comprising:
a radio frequency acceleration electrode that accelerates the ion beam; and a dummy electrode disposed opposite to or parallel with the radio frequency acceleration electrode,
wherein the chimney is electrically connected to the dummy electrode via a contact.

4. The ion source according to claim 2, wherein
the chimney is formed in a cylindrical shape, and
an extraction hole for extracting the ion beam is provided on a side of the radio frequency acceleration electrode in a peripheral wall of the chimney.

5. The ion source according to claim 2, wherein
a bulging portion bulging toward the extraction hole is formed on an inner peripheral surface of the chimney facing the extraction hole, and
a distal end portion of the cathode overlaps the bulging portion in an insertion direction of the cathode.

6. The ion source according to claim 1, wherein the chimney is formed in a cylindrical shape, and the pair of cathodes is inserted from openings on both sides.

7. The ion source and the circular accelerator according to claim 1, further comprising:
a cathode holder configured to hold one end of the cathode; and
a cathode fixture that is provided with an insertion hole into which the cathode is inserted and supports the cathode holder when the cathode is inserted into the insertion hole,
wherein a tapered surface expanding in diameter toward a side opposite to an insertion direction of the cathode is formed in an opening of the insertion hole on a side opposite to the insertion direction.

8. The ion source according to claim 7, wherein the cathode holder is formed with a tapered surface facing the tapered surface.

9. The ion source according to claim 1, wherein
an anode is attached to each of the pair of cathodes, and
the cathode and the anode are each inserted into the chimney.

10. The ion source according to claim 9, wherein an opening edge of the chimney is formed with a tapered surface expanding in diameter toward a side opposite to the insertion direction of the cathode.

11. The ion source according to claim 10, wherein the anode is formed with a tapered surface that faces the tapered surface when the chimney is inserted.

12. An accelerator comprising the ion source according to any one of claims 1 to 11.

13. A particle beam therapy system comprising: the accelerator according to claim 12; a beam transport system; an irradiation device; and a treatment couch.
